Europäisches Patentamt

European Patent Office

Office européen des brevets

(11) Veröffentlichungsnummer: **0 299 380**
**A2**

# EUROPÄISCHE PATENTANMELDUNG

(21) Anmeldenummer: 88110938.3

(22) Anmeldetag: 08.07.88

(51) Int. Cl.⁴: **H05K 1/02**

(30) Priorität: **16.07.87 DE 8709795 U**

(43) Veröffentlichungstag der Anmeldung:
**18.01.89 Patentblatt 89/03**

(84) Benannte Vertragsstaaten:
**AT CH DE FR GB IT LI NL**

(71) Anmelder: **Zacherl, Manfred**
**Bernöderweg 9**
**D-8250 Dorfen 1(DE)**

(72) Erfinder: **Zacherl, Manfred**
**Bernöderweg 9**
**D-8250 Dorfen 1(DE)**

(54) **Platine für gedruckte Transistorschaltungen, insbesondere für Laborzwecke.**

(57) Die Erfindung betrifft eine universelle Leiterbahnstruktur für gedruckte Schaltungen , auf der verschiedene Standard-, und Spezialschaltungen mit genormten Bauelementen verschiedener Art-(Widerstände,Kondensatoren,Trimmer, Microschalter und mindestens einem Transistor)realisierbar sind.

Zugleich soll diese universalstruktur als Bestückungsfertige Standardleiterplatine mit Modulcharakter eingesetzt werden.

Dem Professionellen sowie Amateurelektroniker ist somit durc h die bloße Schaltbildvorlage eine fertig bestückte Platine in wenigen Minuten möglich. Die logische Anordnung des Leiterbahnver laufes wird maßgeblich bestimmt :

1) durch das in die Mitte gelegte Transistor-Ausgangsfeld, von dem aus, der geplante Transistor jede Hauptbahn (1-6) problemlos erreicht.

2) daß die Hauptbahnen (1-4) untereinander im Mindestfall durch 2 fachen Rasterabstand erreichbar sind.

3) daß die Hauptbahnen parallel zueinander,-schichtartig in abgestufter Form, von der Mitte nach aussen abgelegt sind, um eine brückenlose Verbindungsmöglichkeit aller Hauptbahnen untereinander durch Bauelemente unterschiedlicher Raster zu ermöglichen.

4) durch die Aufnahmemöglichkeit von Trimmern die eine zusätzliche Winkelform der Bahnen erfordert.

5) durch den Modulcharakter der ein ineinandergreifen der Bahnen, bei anreihung mehrerer Grundplatinen ermöglicht.

Fig. - 4

Fig. - 5

R 1    R 2    C 2    R 3    C 1    Tr 1

## Platine für gedruckte Transistorschaltungen, insbesondere für Laborzwecke

Die Neuerung bezieht sich auf eine Platine für gedruckte Transistorschaltungen, insbesondere für Laborzwecke, mit den Merkmalen des Oberbegriffs des Schutzanspruches 1.

Es sind die verschiedensten Laborkarten mit gedruckten Schaltungen bekannt. So ist auch bereits eine Laborkarte bekannt, die aus einer mit einem gleichmäßigen Lochraster versehenen Hartpapierplatte besteht. Die Lochmatrix besitzt einen Raster von 2.54 mm. Es sind parallele Kupferstreifen als Leiterbahnen aufgebracht. Nachteilig ist, daß die Bauelemente zum Aufbau einer Schaltung nicht mit gleichen Rastergrößen einsetzbar sind. Außerdem ist der Aufbau der unterschiedlichsten Schaltungen unter Verwendung einer solchen Laborkarte nicht besonders einfach.

Der Neuerung liegt die Aufgabe zugrunde, eine Platine für gedruckte Transistorschaltungen, insbesondere für Laborzwecke so zu verbessern, daß die Bestückung und der Aufbau mit Bauelementen auch für komplexere Schaltungen vereinfacht und die Bauelemente mit möglichst gleichem Abstand einsetzbar sind.

Die Neuerung löst diese Aufgabe mit den kennzeichnenden Merkmalen des Schutzanspruches 1.

Der Aufbau des Grundmoduls nach der Neuerung ermöglicht eine Verbindung aller Bauelemente mit unterschiedlichen Rastergrößen. Eine unter Verwendung solcher Module in Nebeneinander- und/oder in Hintereinanderanordnung aufgebaute Platine z.B. im Euro-Format 160 x 100 erlaubt die Vervielfachung der Aufnahme der Bauelemente, wodurch auch komplexere Schaltungen realisierbar sind. Bei bestückten Platinen kann die Schaltung infolge des übersichtlichen Aufbaus leicht rekonstruiert werden. Auch können etwaige Schaltungsfehler leichter erkannt werden.

Weitere Ausgestaltungen der Neuerung ergeben sich aus den Unteransprüchen.

Die Neuerung wird nachfolgend anhand von in der Zeichnung dargestellten Ausführungsbeispielen näher erläutert. In der Zeichnung zeigen:

Fig. 1 eine schematische Draufsicht auf eine Laborplatine mit gedrucktem Schaltungsmodul in vergrößertem Maßstab;

Fig. 2 eine Draufsicht auf eine Laborplatine mit Hintereinanderanordnung eines Moduls nach Fig. 1;

Fig. 3 eine Draufsicht einer Laborplatine mit hintereinander und nebeneinander angeordneten Modulen nach Fig. 1;

Fig. 4 ein übliches Schaltschema einer Transistor-Verstärkerstufe;

Fig. 5 eine Laborplatine nach Fig. 1 mit aufgelöteten Schaltelementen zur Herstellung einer Verstärkerstufe nach Fig. 4.

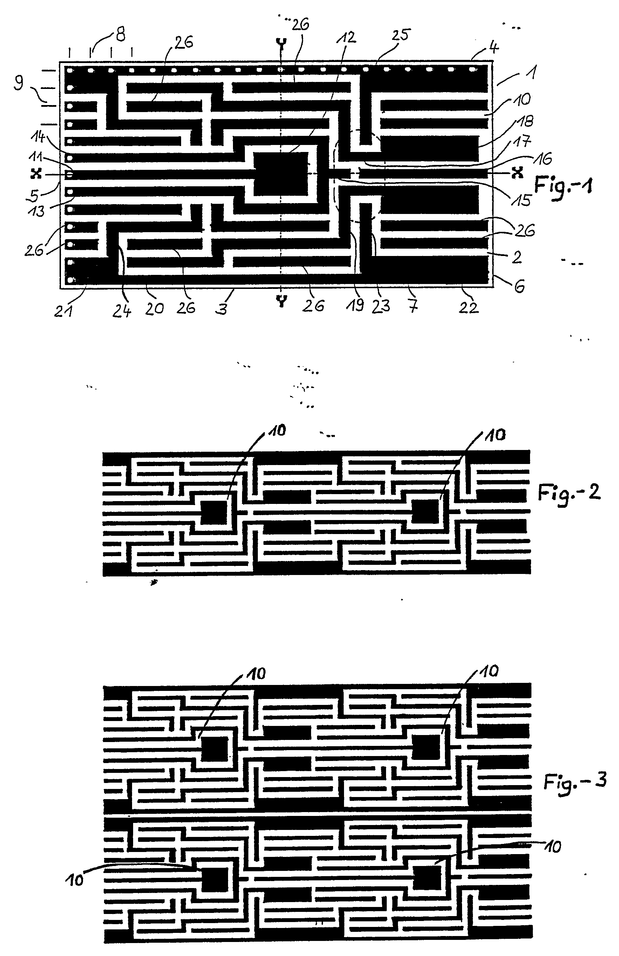

Die Laborplatine 1 nach Fig. 1 besteht wie üblich aus einer Isolierplatte 2 von rechteckiger Form. Diese besitzt Längsränder 3, 4 und Seitenränder 5, 6.

Auf diese Isolierplatte 2 sind Leiterbahnen 7 als gedruckte Schaltung aufgebracht.

Die Isolierplatte besitzt in gleichbleibenden Rasterabständen Lochreihen 8, 9 zur Befestigung der eingesteckten Enden von Bauelementen.

Das in Fig. 1 in vergrößertem Maßstab dargestellte Modul kann auf einer z.B. genormte Abmessungen besitzende Platine nach den Figuren 2 und 3 in Hintereinander- oder in Hintereinander- und Nebeneinanderanordnung sich wiederholen.

Das Modul 10 weist eine Symmetrieachse x-x auf, die senkrecht zu den Seitenrändern 5, 6 verläuft.

Mit dieser Symmetrieachse x-x fällt die Signalleiterbahn 11 zusammen. Diese beginnt am linken Seitenrand 5 und erstreckt sich bis zur Mittelachse y-y, die sich vom Seitenrand 3 zum Seitenrand 4 erstreckt. In der Mitte des Moduls 10 weist diese Signalleiterbahn 11 eine rechteckförmige Vergrößerung 12 auf.

Symmetrisch zur Signalleiterbahn 11 verlaufen im gleichen Rasterabstand die geraden Basisleiterbahnen 13, 14. Einen Rasterabstand vor der rechteckförmigen Vergrößerung 12 springen die Basisleiterbahnen 13, 14 um einen Rasterabstand von der Symmetrieachse x-x weg, setzen sich parallel zur Achse x-x fort und springen unter Beibehaltung des einen Rasterabstandes wieder in Richtung zur Symmetrieachse x-x zurück, um sich dort zu vereinigen. In der Symmetrieachse x-x liegend setzt sich die Basisleiterbahn in ein kurzes Stück 15 fort. Mit einem freibleibenden Rasterabstand setzt sich diese Basisleiterbahn schließlich in ein Leiterstück 16 in der Symmetrieachse x-x liegend zum Seitenrand 6 fort.

Die Kollektorleiterbahn 17 schließt sich an die Basisleiterbahn, und zwar an deren Fortsetzungsstücken 15, 16, mit einem Rasterabstand an und verläuft parallel zu diesen zum rechten Seitenrand 6. Sie geht dabei in den verdickten Bereich 18 über. Gegenüber dem ringförmigen Basisleiterbahnkranz 13, 14 springt sie unter Beibehaltung eines Rasterabstandes in Richtung zum Längsrand 4 hin und verläuft unter Einhaltung von zwei Rasterabständen schließlich wieder parallel zur Basisleiterbahn bis sie um einen Rasterabstand versetzt in Richtung zum Längsrand 4 hin und dann wiederum parallel zur Mittelachse x-x weiterläuft. Die Kollek-

torleiterbahn 17 endet dabei vor dem Seitenrand 5 mit einem dreifachen Rasterabstand.

Symmetrisch zur Kollektorleiterbahn 17 ist die Emitterleiterbahn 19 spiegelbildlich zur Symmetrieachse x-x angeordnet.

Am Längsrand 3, parallel dazu, verläuft über dessen ganze Länge die Minus-Pol-Anschlußleiterbahn 20. Diese besitzt verbreiterte Leiterbahnstücke 21, 22 und setzt sich über Fortsätze 23 gerade in Richtung zur Emitterleiterbahn bzw. mit einem abgeknickten Fortsatz 24 ebenfalls zur Emitterleiterbahn 19 fort.

Symmetrisch dazu und spiegelbildlich zu x-x Achse ist die Plus-Pol-Anschlußleiterbahn 25 am Längsrand 4 angeordnet.

Zwischen den Signalleiterbahnen 11 und den äußeren Minus-bzw. Plus-Pol-Anschlußleiterbahnen 20, 25 sowie der Kollektorleiterbahn 17 bzw. der Emitterleiterbahn 19 sind Leiterbahnstücke 26 parallel zu den Längsrändern 3, 4 in gerader bzw. abgewinkelter Form angeordnet, um jeweils einen Rasterabstand zu benachbarten Leiterbahnen zu bilden.

Die Anschlußstellen für einen Transistor liegen in dem strichliert angegebenen Bereich.

Ein so aufgebautes Modul 10, welches eine Abmessung von ca. 50 x 30 besitzen kann, kann sich, wie aus Fig. 2 ersichtlich, in Hintereinandernordnung auf einer vergrößerten Basisplatine fortsetzen.

Wie aus Fig. 3 ersichtlich, ist es auch zusätzlich möglich, die Module 10 parallel anzuordnen.

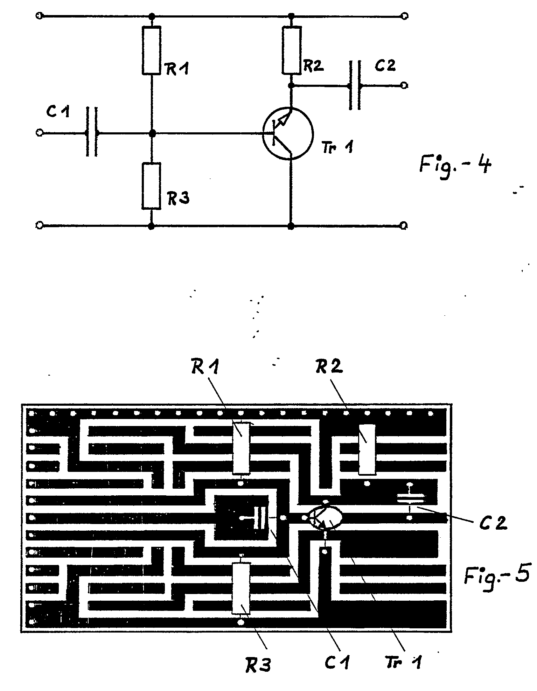

Die Figur 5 zeigt wie eine übliche Transistor-Verstärkerstufe nach Fig. 4 mit seinen Bauelementen auf einem Modul 10 anzuordnen ist.

Es können auch Trimmer und Mikroschalter infolge der Winkelform der Hauptleiterbahn und der zwischengefügten Leiterbahnstücke eingesetzt werden.

## Ansprüche

1. Platine für Transistorschaltungen, insbesondere für Laborzwecke, mit einer rechteckigen Isolierplatte mit in Rasterabständen angebrachten Lochreihen und mit Leiterbahnen in Form eines Moduls, von denen äußere, parallele, den Längsrändern des Moduls zugeordnete Leiterbahnen an elektrische Plus- und Minus-Versorgungsanschlüsse anschaltbar sind und von denen die Signal-, Kollektor-, Emitter- und Basisanschlüsse für Transistoren als Leiterbahnen dazwischen in Rasterabständen angeordnet sind, dadurch gekennzeichnet, daß die Signal-Leiterbahn (11, 12) von einem Seitenrand (5) des Moduls (10) in der Längssymmetrieachse (x-x) bis auf einen Abstand an den Basistransistoranschluß herangeführt ist, daß die Leiterbahn (13, 14, 15) des Basis-Transistoranschlusses um einen Rasterabstand dazu versetzt angeordnet ist und daß die Leiterbahnen (17, 19) für die Kollektor- und Emitteranschlüsse symmetrisch zur Längssymmetrieachse (x-x) angeordnet sind und mit wenigstens einem Rasterabstand zur Signalleiterbahn in Richtung zum einen Seitenrand (5) geführt sind.

2. Platine nach Anspruch 1, dadurch gekennzeichnet, daß die die Signalleiterbahn (11) in der Modulmitte eine rechteckförmige Vergrößerung (12) besitzt.

3. Platine nach den Ansprüchen 1 und 2, dadurch gekennzeichnet, daß die Basisleiterbahn (13, 14) von einem Seitenrand (5) des Moduls (10) ausgehend symmetrisch zur Symmetrieachse (x-x) ausgebildet ist, deren Enden als Kranz mit einem Rasterabstand die rechteckförmige Vergrößerung (12) der Signalleiterbahn (11) umgeben, der sich in ein mittiges Leiterbahnfortsatzstück (15) fortsetzt, das mit einem Rasterabstand dann als ein mittiges Leiterbahnstück (16) bis zum Seitenrand (6) des Moduls weitergeführt ist.

4. Platine nach den Ansprüchen 1 bis 3, dadurch gekennzeichnet, daß die Kollektorleiterbahn (17) sich vom Seitenrand (6) im Rasterabstand parallel zum Leiterstück (16) der Signalleiterbahn (11) bis zum Kollektoranschluß eines Transistors erstreckt, im Rasterabstand vom Basisleiterbahnhang senkrecht zur Symmetrieachse (x-x) zurückspringt und dann im Mehrfach-Rasterabstand wieder parallel zur Symmetrieachse verläuft, um dann nochmals um einen Rasterabstand zurückzuspringen, wobei diese Leiterbahn im Mehrfach-Rasterabstand vom Seitenrand (5) des Moduls (10) endet.

5. Platine nach den Ansprüchen 1 bis 5, dadurch gekennzeichnet, daß das die Emitterleiterbahn (19) bezüglich der Symmetrieachse (x-x) spiegelbildlich zur Kollektorleiterbahn (17) angeordnet ist.

6. Platine nach den Ansprüchen 1 bis 4, dadurch gekennzeichnet, daß die Enden der Kollektorleiterbahn (17) und der Emitterleiterbahn (19) zum Seitenrand (6) des Moduls (10) hin verbreitert sind.

7. Platine nach Anspruch 1, dadurch gekennzeichnet, daß die Minus-Anschlußleiterbahn (20) verbreiterte Endteile (21, 22) besitzt, deren nach einwärts gelegene Enden mit geraden Fortsätzen (23) bzw. mehrfach abgewinkelten Fortsätzen (24) nach einwärts ragen.

8. Platine nach Anspruch 7, dadurch gekennzeichnet, daß die Plus-Anschlußleiterbahn (25) bezüglich der Symmetrieachse (x-x) des Moduls spiegelbildlich zur Minus-Anschlußleiterbahn (20) ausgebildet ist.

9. Platine nach den Ansprüchen 1 bis 8. dadurch gekennzeichnet, daß in den Zwischenräumen zwischen den Leiterbahnen gerade bzw. abgewinkelte Leiterbahnstücke (26) parallel zur Symmetrieachse (x-x) angeordnet sind, die jeweils einen Rasterabstand zu benachbarten Leiterbahnteilen herstellen.

10. Platine nach den Ansprüchen 1 bis 9. dadurch gekennzeichnet, daß Module (10) hintereinander und oder nebeneinander angeordnet sind.

Fig.-1

Fig.-2

Fig.-3

R1    R2    C2

C1

R3

Tr 1

Fig.- 4

R1    R2

C2

R3    C1    Tr 1

Fig.- 5